# FASCICULE DE BREVET EUROPEEN

(11) **EP 2 959 036 B1**
(45) Date de publication et mention de la délivrance du brevet: **28.12.2016**
(21) Numéro de dépôt: 14713167.6
(22) Date de dépôt: 21.02.2014
(51) Int. Cl.: C23C 18/18, C23C 18/16, C23C 18/34, C23C 18/36, H01L 21/28, H01L 21/288, C23C 18/54, H01L 21/285, H01L 31/0224

(54) **PROCÉDÉ DE FORMATION D'UN SILICIURE MÉTALLIQUE A L'AIDE D'UNE SOLUTION CONTENANT DES IONS OR ET DES IONS FLUOR**
VERFAHREN ZUR HERSTELLUNG EINES METALLSILIZIDS MIT EINER LÖSUNG MIT GOLDIONEN UND FLUORIONEN
METHOD FOR FORMING A METAL SILICIDE USING A SOLUTION CONTAINING GOLD IONS AND FLUORINE IONS

(30) Priorité: 22.02.2013 FR 1351593
(43) Date de publication de la demande: 30.12.2015
(73) Titulaire: aveni, 91300 Massy (FR)
(72) Inventeur: MEVELLEC, Vincent, F-92370 Chaville (FR); SUHR, Dominique, F-92290 Chatenay Malabry (FR)
(74) Mandataire: Chantraine, Sylvie Hélène
(86) Numéro de dépôt international: PCT/FR2014/050365
(87) Numéro de publication internationale: WO 2014/128420

(56) Documents cités:
- US-A- 3 373 054
- US-A- 4 152 824
- US-A1- 2003 214 017
- US-A1- 2004 005 468
- US-A1- 2006 251 801
- US-A1- 2007 295 995
- US-B1- 6 566 254
- MAGAGNIN L ET AL: "Selective deposition of gold nanoclusters on silicon by a galvanic displacement process", MICROELECTRONIC ENGINEERING, ELSEVIER PUBLISHERS BV., AMSTERDAM, NL, vol. 64, no. 1-4, octobre 2002 (2002-10), pages 479-485, XP004381220, ISSN: 0167-9317, DOI: 10.1016/S0167-9317(02)00824-9
- LU ET AL: "Nonionic surfactant-capped gold nanoparticles as postcolumn reagents for high-performance liquid chromatography assay of low-molecular-mass biothiols", JOURNAL OF CHROMATOGRAPHY, ELSEVIER SCIENCE PUBLISHERS B.V, NL, vol. 1163, no. 1-2, 7 septembre 2007 (2007-09-07), pages 328-332, XP022202221, ISSN: 0021-9673, DOI: 10.1016/J.CHROMA.2007.07.045
- YAZHUO SHANG ET AL: "Synthesis of gold nanoparticles by reduction of HAuCl4 under UV irradiation", SOLID STATE SCIENCES, vol. 15, janvier 2013 (2013-01), pages 17-23, XP055124303, ISSN: 1293-2558, DOI: 10.1016/j.solidstatesciences.2012.09.002

## Description

La présente invention concerne de manière générale la fabrication de dispositifs électroniques, tels que notamment des mémoires NAND effaçables utilisées dans les clés USB, les cartes MS et les cartes SD pour le stockage et le transfert général des données.

La présente invention se rapporte à la fabrication de siliciure métallique par dépôt chimique de métal sur du silicium. Elle porte en particulier sur l'activation d'un substrat comprenant une alternance verticale par rapport à sa surface de couches d'un diélectrique et d'un semi-conducteur, pour son revêtement ultérieur avec une fine couche métallique déposée par un procédé electroless, encore appelé auto-catalytique.

Le siliciure de nickel est généralement formé par dépôt d'un film de nickel sur le substrat de silicium par un procédé en phase vapeur, suivi d'un traitement thermique rapide (RTA, Rapid Thermal Anneal). Au cours de ce traitement thermique à une température généralement de l'ordre de 400 à 750°C, le nickel migre dans la couche de silicium pour former le siliciure de nickel. Le nickel qui n'a pas migré dans le silicium et qui est resté en surface du substrat peut ensuite être retiré par nettoyage chimique sélectif sans endommager le siliciure formé.

Le siliciure de nickel est notamment utilisé pour la fabrication d'interconnexions dans des dispositifs à semi-conducteurs utilisés dans des circuits intégrés VLSI. Les dépôts de siliciure de nickel sont également utiles dans la fabrication de mémoires NAND, et des transistors MOS.

Les mémoires flash NAND stockent des informations dans un réseau de cellules mémoire constitué de transistors à grille flottante (MOS) qui sont connectés en série. Dans les NAND en trois dimensions, il est souhaitable de pouvoir réaliser des dépôts de siliciure de nickel très fins d'épaisseur uniforme sur l'ensemble de la surface des structures dont les facteurs de forme sont très élevés, notamment des puits de quelques dizaines de nanomètres d'ouverture et de quelques microns de profondeur.

Les transistors MOS (métal-oxyde-semiconducteur) utilisent souvent des couches de siliciure métallique (siliciure de titane, de cobalt ou de tungstène) pour réduire la résistance entre deux matériaux.

Dans des transistors MOS de faible longueur de grille ou les transistors MOS à jonctions peu profondes, il est nécessaire de réaliser des dépôts de nickel plus fins, car le nickel a un coefficient de diffusion dans le silicium très élevé conduisant à la formation de zones de siliciure de nickel qui peuvent s'étendre au-dessous des parois latérales des structures de transistor, et entraîner des défauts de fonctionnement.

Afin d'obtenir une couche de nickel d'épaisseur uniforme, il est généralement nécessaire d'activer la surface de silicium avec du palladium. Le brevet US 6 406 743 a notamment décrit un procédé de fabrication de siliciure de nickel comprenant l'activation de la surface de silicium polycristallin avec un sel de chlorure de palladium en solution dans de l'acide fluorhydrique et de l'acide acétique à température ambiante pendant une dizaine de secondes. Après cette étape d'activation, une couche de nickel d'épaisseur 180-220 nm est déposée par voie electroless, par exemple avec une solution de sulfate de nickel et de diméthylamine borane en présence d'agents complexants du nickel, tels que l'acide lactique et l'acide citrique. Le siliciure de nickel est formé en portant le nickel à haute température (650°C) de manière à le faire migrer dans le silicium.

La Demanderesse a cependant constaté que l'activation avec du palladium ne permet pas d'obtenir des couches nickel d'épaisseur faible et uniforme, car la densité d'activation du palladium à la surface du silicium est trop faible. La Demanderesse a également pu constater qu'en utilisant de l'argent ou du cuivre pour activer la surface de silicium, on obtient une couche de nickel fine et régulière, mais le siliciure de nickel ne se forme pas au cours de l'étape de traitement thermique rapide (RTA).

La demande de brevet US 2004/005468 décrit quant à elle un procédé d'activation avec du trichlorure d'or en solution avec du bifluorure d'ammonium.

Il a déjà été proposé de déposer le nickel par un procédé en phase vapeur. Cependant, les procédés de dépôt chimique en phase vapeur (CVD ou ALD) sont coûteux. Ils présentent également le désavantage, lorsqu'ils sont appliqués à des substrats présentant des puits ou des gravures, de former des dépôts très épais à l'ouverture et sur les angles aigus des structures plutôt que dans leurs fonds. Lorsque les facteurs de formes deviennent trop importants, par exemple supérieurs à 5:1, par exemple de l'ordre de 10:1, l'épaisseur des couches déposées par CVD devient trop faible au fond des structures.

Il subsiste donc un besoin d'obtenir une couche de nickel régulière de faible épaisseur qui puisse migrer dans le silicium par un traitement thermique rapide à des températures les plus basses possibles afin de réduire les coûts de fabrication. Cette couche doit être obtenue selon un procédé industriel peu coûteux et facile à mettre en oeuvre. C'est pourquoi on a cherché à déposer le nickel par voie auto-catalytique et non en phase vapeur.

Il a été découvert dans le cadre de la présente invention que cet objectif peut être atteint en utilisant un sel d'or en solution aqueuse et une source de fluor en présence d'un agent tensio-actif particulier.

L'invention a donc pour premier objet un procédé de formation de siliciure de nickel ou de siliciure de cobalt comprenant les étapes consistant à :
- mettre en contact la surface d'un substrat comprenant du silicium avec une solution aqueuse contenant des ions or et des ions fluor pour former des particules d'or métallique (Au 0),
- déposer par voie electroless, sur le substrat recouvert de particules d'or métallique, une couche constituée essentiellement de nickel ou de cobalt,
- appliquer un traitement thermique rapide (RTA) à une température comprise entre 300°C et 750°C, de manière à former le siliciure de nickel ou le siliciure de cobalt.

Le dépôt de nickel obtenu selon le procédé de la présence invention respecte un cahier des charges complexe :
- il est adhérent au substrat de silicium,
- il est d'épaisseur constante sur toute la surface du substrat quelle que soit sa typologie (plane ou gravée), et ce même à faible épaisseur, typiquement inférieur à 50 nm, et
- il diffuse dans le silicium lors d'un traitement thermique rapide, même à basse température, typiquement de l'ordre de 350°C.

Dans les structures dont la surface comprend une alternance de zones de silicium et de zones d'isolant, le procédé de l'invention permet avantageusement de réaliser un dépôt sélectif du nickel ou du cobalt sur le silicium, ce qui limite l'usage excessif de matières premières, et les coûts associés à une étape d'élimination du nickel n'ayant pas migré dans le silicium, à l'issu du RTA.

Pour une application dans le domaine de la microélectronique, le substrat de silicium pourra être constitué d'un coupon de silicium recouvert d'une couche de dioxyde de silicium (SiO₂) ayant une épaisseur comprise entre 70 et 110 nm, puis d'une couche de silicium, par exemple polycristallin, ayant une épaisseur comprise entre 150 et 230 nm.

On entend par silicium polycristallin, aussi couramment appelé polysilicium ou poly-Si, une forme particulière du silicium, qui se différencie du silicium monocristallin et du silicium amorphe. Contrairement au premier (composé d'un seul cristal) et au second (n'ayant aucune ou une très faible cohérence cristallographique), le silicium polycristallin est constitué de multiples petits cristaux de tailles et de formes variées.

La première étape du procédé de l'invention consiste à mettre en contact la surface d'un substrat comprenant du silicium avec une solution aqueuse contenant des ions or et des ions fluor pour former des particules d'or, encore appelés grains d'or, à la surface du substrat de silicium.

La solution aqueuse contient de préférence de 0.1 mM à 10 mM d'ions or, de préférence de 0.1 mM à 5.0 mM, et de préférence encore de 0.5 mM à 1.0 mM d'ions or. La concentration en ions or est par exemple comprise entre 0.65 mM et 0.75 mM.

Dans la présente demande, les expressions « allant de ... à » et « contenant de ... à » désignent des plages de valeurs comprenant les bornes. L'expression « entre ... et » exclut les bornes de la plage de valeurs.

La solution aqueuse contient de préférence de 0.6 M à 3.0 M d'ions fluor, de préférence de 1.0 à 2.0 M, et de préférence encore de 1.4 à 1.6 M d'ions fluor.

Les ions fluor peuvent être apportés par de l'acide fluorhydrique (HF), NH₄F ou par un mélange NH₄F/HF.

La solution aqueuse contient de préférence de 0.6 M à 3.0 M d'acide fluorhydrique (HF), de préférence de 1.0 M à 2.0 M, et de préférence encore de 1.4 M à 1.6 M d'acide fluorhydrique (HF).

Les ions or peuvent être apportés par un sel d'or choisi parmi les sels d'or (I) et (III), comme les chlorures d'or (I), les chlorures d'or (III) ou le bromure d'or (III). On choisit par exemple l'acide chloraurique (HAuCl₄).

La solution aqueuse contient de préférence de 0.1 mM à 10 mM d'ions or (III), de préférence de 0.1 à 5.0 mM, et de préférence encore de 0.5 à 1.0 mM d'ions or (III). La concentration en ions or (III) est par exemple comprise entre 0.65 et 0.75 mM.

Selon un mode de réalisation préféré, la solution aqueuse contient
- de 0.1 mM à 10 mM, de préférence de 0.5 mM à 1.0 mM, d'ions or, et
- de 0.6 M à 3.0 M, de préférence de 1.0 M à 2.0 M, d'ions fluor.

La solution aqueuse peut contenir des composés acides organiques ou inorganiques, qu'ils soient forts ou faibles, de manière à faire varier la vitesse d'attaque du silicium, notamment l'augmenter ou la diminuer. Dans un mode de réalisation, la solution aqueuse est dépourvue d'acide acétique CH₃COOH.

La solution peut contenir en outre un agent tensio-actif, si l'on veut réduire davantage l'épaisseur de la couche de nickel ou de cobalt que l'on souhaite déposer dans une étape ultérieure.

L'agent tensio-actif peut être choisi parmi les composés comprenant au moins un groupement polaire anionique ou non ionique et une chaîne alkyle comprenant au moins 10 atomes de carbone, par exemple de 10 à 16 atomes de carbone, de préférence de 10 à 14 atomes de carbone. La chaîne alkyle est de préférence linéaire. Elle comprend avantageusement 12 atomes de carbone (également appelée dodécyle).

Ce tensio-actif particulier permet de stabiliser les nanoparticules d'or formées après réaction d'oxydo-réduction avec le silicium polycristallin. Il permet également d'augmenter leur nombre et de les disperser davantage à la surface du silicium. En ajoutant ce tensio-actif dans le bain d'activation, la taille des particules d'or métallique peut être diminuée tout en augmentant leur densité. Les inventeurs ont mis en évidence que des tensio-actifs de plus grosse taille ne permettent pas d'obtenir un résultat aussi avantageux.

Cette répartition des particules d'or permet de déposer des couches de de nickel puis de siliciure de nickel, qui sont très fines et continues à la fois, ce que ne permettent pas les procédés de l'art antérieur pour lesquels il est nécessaire de déposer plus de nickel pour garantir un dépôt régulier sur toute la surface du silicium. L'épaisseur de la couche de nickel peut avantageusement être inférieur à 150 nm, par exemple être comprise entre 10 et 45 nm. Dans certaines applications, elle peut être de l'ordre de 10 à 25 nm.

On préfère un tensio-actif ionique, cationique ou anionique, qui permet une stabilisation à la fois électrostatique et stérique des nanoparticules sur la surface du silicium polycristallin.

L'agent tensio-actif peut avoir une masse moléculaire comprise entre 100 g/mol et 5000 g/mol, de préférence une masse moléculaire comprise entre 100 g/mol 1 500 g/mol, et de préférence encore une masse moléculaire comprise entre 200 g/mol 500 g/mol.

On préfère notamment un agent tensio-actif anionique ayant une masse moléculaire comprise entre 100 g/mol 1 500 g/mol.

Le groupement polaire peut être un groupement non ionique, de préférence un groupement polyoxyalkylèneglycol, par exemple polyoxyéthylèneglycol ou polyoxypropylèneglycol. Dans ce mode de réalisation, l'agent tensio-actif peut être choisi parmi les polyoxyalkylèneglycol alkyl éthers, de préférence les polyoxyalkylèneglycol alkyl éthers comprenant une chaîne alkyle ayant de 10 à 16 atomes de carbone, comme par exemple les polyoxyéthylèneglycol dodécyl éthers.

Le groupement polaire peut être un groupement anionique tel qu'un sulfonate (-SO₃⁻), un sulfate (-OSO₃⁻), ou un carboxylate (-COO⁻). On préfère un sulfate dans le cadre de l'invention. L'agent tensio-actif est de préférence un sulfate d'alkyle de formule R-OSO₃⁻ dans laquelle R est un groupe alkyle linéaire ayant de 10 à 14 atomes de carbone, de préférence 12 atomes de carbone. L'agent tensio-actif peut-être par exemple le dodécylsulfate de sodium.

L'agent tensio-actif représente de préférence de 0,1 à 5% en poids, par exemple de 2,5 à 3,5% en poids, de la solution.

Selon un mode de réalisation préféré, la solution aqueuse contient de 0.5 mM à 1 mM d'acide chloraurique (HAuCl₄), de 1.0 à 2.0 M d'acide fluorhydrique (HF), et éventuellement 2,5 à 3,5% en poids de dodécylsulfate de sodium par rapport au poids de la composition.

De préférence, cette étape d'activation du substrat de silicium par dépôt de grains d'or métallique à sa surface est réalisée à une température comprise entre 15 et 30°C, et de préférence encore à une température comprise entre 20 et 25°C.

La durée de contact entre la solution aqueuse et le substrat de silicium est généralement de l'ordre de 5 secondes à 5 minutes, de préférence de 10 secondes à 2 minutes, et de préférence encore entre 20 et 40 secondes. On choisira la durée d'activation en fonction de la taille et du nombre de grains d'or que l'on souhaite former à la surface du substrat de silicium. On choisira avantageusement une taille de grains d'or de l'ordre de 5 à 15 nm, de préférence de l'ordre de 10 nm.

La mise en contact de la surface du substrat avec la solution d'activation est réalisée avantageusement par immersion du substrat dans la solution d'activation, éventuellement sous agitation.

Le substrat ainsi traité est avantageusement abondamment rincé à l'eau déionisée et séché sous un flux d'azote, afin de retirer toute trace de solution d'activation.

La deuxième étape du procédé de l'invention consiste à déposer par voie electroless sur le substrat recouvert de particules d'or une couche constituée essentiellement de nickel ou de cobalt. Par essentiellement, on entend plus de 90 % en poids, les autres éléments pouvant être du bore, du phosphore ou du tungsten.

La couche constituée essentiellement de nickel ou de cobalt est avantageusement uniforme lorsqu'elle couvre une surface plane, et conforme lorsqu'elle recouvre des structures en trois dimensions qui ont été creusées dans le silicium (exemple des vias TSV et des tranchées pour mémoire NAND).

L'uniformité au sens de l'invention est égale à la variation de l'épaisseur de la couche constituée essentiellement de nickel ou de cobalt sur la surface recouverte. L'uniformité de la couche constituée essentiellement de nickel ou de cobalt obtenue selon le procédé de l'invention est avantageusement inférieure à 10%, de préférence inférieure à 5%, de préférence encore inférieure à 1%.

La conformalité au sens de l'invention est égale au rapport entre l'épaisseur de la couche en haut et au fond d'une structure. La conformalité au sens de l'invention peut également être égale à la variation de l'épaisseur de la couche sur l'ensemble constitué par le haut, les flancs et le fond de la structure.

La conformalité de la couche constituée essentiellement de nickel ou de cobalt obtenue selon le procédé de l'invention est avantageusement comprise entre 90 et 110%, de préférence supérieure à 95%, de préférence encore supérieure à 99%.

Les tranchées sont généralement gravées dans le silicium, puis métallisées jusqu'à la profondeur souhaitée avant d'amincir la tranche de silicium. La forme et la dimension des tranchées peuvent varier en fonction de l'usage du dispositif. Les tranchées sont couramment caractérisées par leur profondeur, leur diamètre à l'ouverture, et leur facteur de forme (« aspect ratio » en anglais) définissant le rapport entre la profondeur et le diamètre de la cavité. Par exemple, une tranchée de facteur de forme 10:1 a un diamètre de dimension dix fois inférieur à sa profondeur.

La couche constituée essentiellement de nickel ou de cobalt est avantageusement conforme quand elle recouvre la surface de structures très profondes : le rapport de couverture entre le haut et le fond de la structure est avantageusement compris entre 90 et 110% lorsqu'elle recouvre des tranchées présentant des facteurs de forme élevés, notamment supérieurs à 5:1, de préférence supérieur à 10:1.

Le facteur de forme - exprimé comme le rapport entre la profondeur et le diamètre d'ouverture des cavités - peut varier de 5:1 à 1000:1, notamment dans le cas de dispositif de mémoires NAND dont la surface est constituée d'une alternance de couches de silicium polycristallin et de couches de SiO₂. Le procédé selon l'invention permet avantageusement de déposer une couche métallique de nickel dans des cavités présentant des facteurs de forme particulièrement élevés, par exemple supérieur à 10:1 et au-delà. Le facteur de forme des tranchées peut être avantageusement très élevé et être compris entre 10:1 et 1000:1, par exemple entre 50:1 et 500:1 ou entre 100:1 et 200:1.

Le procédé de l'invention permet de recouvrir la surface de cavités ayant un diamètre à leur ouverture allant de 10 à 100 nm, une profondeur allant de 500 nm et 10 microns, avec une couche constituée essentiellement de nickel ou de cobalt ayant une épaisseur comprise entre 10 et 150 nm, dont la conformalité est supérieure à 90%, de préférence supérieure à 95%, de préférence encore supérieure à 99%.

Le dépôt métallique est effectué par un procédé non électrochimique encore appelé autocatalytique ou « electroless », qui ne nécessite pas la polarisation électrique du substrat.

Le dépôt métallique peut être du nickel, du cobalt, un alliage nickel-bore (NiB), un alliage cobalt-bore (CoB), un alliage nickel-phosphore (NiP), un alliage cobalt-phosphore (CoP) ou un alliage cobalt-tungstene-phosphore (CoWP).

Le dépôt de nickel ou de cobalt est de préférence obtenu en exposant le substrat activé à une solution aqueuse comprenant:
- au moins un sel métallique d'ions nickel ou cobalt, de préférence en une concentration comprise entre 10⁻³ M et 1 M ;
- au moins un agent réducteur des ions nickel ou cobalt, de préférence en une quantité comprise entre 10⁻⁴ M et 1 M ; et
- éventuellement, au moins un agent stabilisant des ions nickel ou cobalt, de préférence en une quantité comprise entre 10⁻³ M et 1 M ;

Le sel de nickel ou de cobalt est de préférence un sel soluble dans l'eau choisi dans le groupe constitué par le chlorure, l'acétate, l'acétylacétonate, l'hexafluoro-phosphate, le nitrate, le perchlorate, le sulfate et le tétrafluoroborate.

Un sel métallique préféré dans le cadre de la présente invention est choisi parmi le sulfate de nickel ou de cobalt, le chlorure de nickel ou de cobalt, l'acétate nickel ou de cobalt, ou le sulfamate de nickel ou de cobalt. On choisit par exemple le sulfate de nickel hexahydraté.

Avantageusement, l'agent réducteur peut être choisi dans le groupe constitué par les dérivés du phosphore, les dérivés du bore, le glucose, le formaldéhyde et l'hydrazine.

Les dérivés du phosphore peuvent être choisis parmi l'acide hypophosphoreux (H₃PO₂) et ses sels, et les dérivés du bore peuvent être choisis parmi les complexes de borane.

L'agent réducteur utilisé est avantageusement choisi parmi les dérivés du bore et en particulier parmi le diméthylamino borane, le triméthyl-amino borane, le triéthyl-amino borane, le pyridine borane, le morpholène borane ou le terbutyl-amine borane. De préférence, on utilisera le diméthyl-amino borane (DMAB).

L'agent stabilisant peut être choisi parmi les composés qui peuvent se complexer aux ions nickel ou aux ions cobalt, de manière à éviter la réduction des ions métalliques en solution par l'agent réducteur en absence de catalyseur.

L'agent stabilisant des ions métalliques peut être choisi dans le groupe constitué par l'éthylènediamine et les sels des acides acétique, propionique, succinique, hydroxy-acétique, malonique, amino-acétique, malique ou citrique. On choisit de préférence l'acide citrique ou un de ses sels pour stabiliser les ions Ni ²⁺ ou Co²⁺.

Le pH de la solution aqueuse peut être acide ou basique, et peut être ajusté dans la gamme de pH souhaitée au moyen d'un ou plusieurs composés modificateurs de pH (ou tampons) tels que ceux décrits dans le « Handbook of Chemistry and Physics - 84^{th} Edition » de David R. Lide publié chez CRC Press.

La solution aqueuse peut par exemple comprendre un agent permettant d'ajuster le pH à une valeur comprise entre 3 à 12, par exemple une amine non polymère pour ajuster le pH entre 8 et 12.

D'une façon générale, la couche métallique peut être réalisée par trempage du substrat dans la solution aqueuse définie précédemment, à une température comprise entre 50 et 90°C, de préférence à 65°C, pendant une durée de 30 s à 30 min, selon l'épaisseur de la couche souhaitée.

Une étape préalable de prémouillage du substrat peut être réalisée avant d'exposer le substrat à la solution aqueuse selon l'invention. Le substrat est par exemple immergé dans une solution aqueuse ou une solution contenant le sel métallique avec son stabilisant, mais sans réducteur. On utilise de préférence de l'eau déionisée. L'ensemble est soumis à une dépression en deçà de 500 mbar pendant 1 à 30 min, de préférence pendant 5 à 15 min.

L'étape de dépôt de la couche de nickel ou de cobalt pourra être réalisée en mettant le substrat à revêtir en rotation à une vitesse comprise entre 20 et 600 tours par minute, en imposant des ultrasons ou des mégasons, ou encore en imposant une simple recirculation de la solution aqueuse dans le réacteur.

Avec la solution aqueuse décrite précédemment, utilisée dans la gamme de température générale précitée, on a obtenu un film métallique présentant une épaisseur comprise entre 6 et 200 nanomètres pour une durée de contact comprise entre 1 min et 20 min.

Selon un mode de réalisation, la couche constituée essentiellement de nickel ou de cobalt est une couche de nickel-bore déposée en exposant la surface du substrat activé à une solution aqueuse contenant un sel de nickel, un agent réducteur à base de bore, et un agent stabilisant, le pH de la solution étant compris entre 9 et 12, et la température de la solution aqueuse étant comprise entre 50°C et 90°C.

La solution aqueuse contenant le sel de nickel peut avantageusement contenir en outre un agent suppresseur qui s'adsorbe à la surface de la couche métallique se formant au fur et à mesure.

Le suppresseur est de préférence un polymère comprenant des groupes ou fonctions « amine », notamment choisi parmi les polymères et copolymères dérivés des chitosans, des poly(allyl-amine), des poly(vinyl-amine), des poly(vinyl-pyridine), des poly(amino-styrène), des poly(éthyleneimine), des poly(L-lysine), et les formes acides (ou protonés) de ces polymères.

Selon un mode de mise en oeuvre de l'invention, on préfère utiliser un homopolymère ou copolymère de la poly(éthylèneimine) sous sa forme non protonée.

On choisira par exemple une poly(éthylèneimine) linéaire avec une masse moléculaire moyenne en nombre Mₙ comprise entre 500 et 25 000 g/mol.

La concentration en polymère doté de fonctions amines utilisé selon la présente invention va avantageusement de 1 à 250 ppm, plus particulièrement de 1 à 100 ppm, de préférence encore de 1 à 10 ppm, par exemple de 1.5 à 3 ppm (1 ppm équivalant à 1 mg/kg de solution).

Lorsque le polymère doté de fonctions amines est une poly(éthylèneimine), le pH de la solution aqueuse va avantageusement de 8 à 12, de préférence de 8,5 à 10. Il est notamment de l'ordre de 9, par exemple entre 8,9 et 9,1. Dans ce cas, on pourra utiliser l'hydroxyde de tétraméthylammonium (TMAH), la triéthanol-amine, la N,N-diméthyl-éthanolamine ou la N-méthyl-éthanolamine comme agent permettant d'ajuster le pH.

L'épaisseur de la couche de nickel ou de cobalt est de préférence uniforme ou conforme. Elle est comprise entre 10 nm et 150 nm, de préférence encore entre 10 nm et 100 nm, voir même entre 10 nm et 40 nm. L'épaisseur de la couche de nickel ou de cobalt peut être même comprise entre 10 nm et 20 nm.

Le substrat recouvert de la couche métallique de nickel ou de bore peut subir ensuite un traitement thermique rapide bien connu de l'homme du métier. La température est généralement comprise entre 300°C et 750°C, de manière à former le siliciure de nickel ou le siliciure de cobalt. Sous l'effet de la chaleur, les atomes de nickel ou de cobalt migrent dans la couche de silicium. Par rapide, on entend généralement moins de 5 minutes, par exemple moins de 3 minutes.

La température peut être abaissée entre 300°C et 500°C, voir même entre 350°C et 450°C, par exemple être comprise entre 325°C et 375°C. Selon un mode de réalisation de l'invention, on réalise le traitement thermique rapide à une température comprise entre 325°C et 375°C pendant 30 secondes à 2 minutes.

Le traitement thermique peut être réalisé avec un four tubulaire ou une plaque chauffante.

Un four tubulaire est un four électrique chauffant en forme de tube permettant d'accueillir des échantillons de formes et tailles variées. Dans le cadre de l'invention, il accueille des tubes en verre, contenant les échantillons, par chargement dans l'axe longitudinal. Un flux d'un gaz choisi et contrôlé peut être associé au chauffage de l'ensemble à l'intérieur du tube de verre.

Dans le cadre des applications préférées de l'invention, le procédé qui vient d'être décrit peut être complété par une étape d'élimination du nickel ou du cobalt qui n'a pas migré dans le silicium et qui est resté à la surface du substrat de silicium, à l'issue de l'étape de RTA.

Aussi, le nickel ou le cobalt qui n'a pas migré dans le silicium à l'issue de l'étape de traitement thermique peut être éliminé par nettoyage chimique.

Le substrat comprenant du silicium peut être un substrat constitué de silicium, de préférence polycristallin. Le substrat pourra comprendre une alternance verticale à sa surface de zones de silicium et de zones d'un diélectrique choisi parmi SiO₂, Si₃N₄, SiOC et SiC. L'invention présente l'avantage de permettre un dépôt sélectif su nickel sur les zones de silicium ; les zones de diélectrique ne sont pas recouvertes de nickel, ce qui limite la consommation inutile de métal.

Le substrat comprenant du silicium à revêtir pourra être plan sans motif, ou plan et comprendre des structures verticales creuses présentant des dimensions telles que leur diamètre à l'ouverture est compris entre 20 et 100 nm, et leur profondeur est comprise entre 500 nm et 3 microns.

Le procédé de l'invention trouve application dans la fabrication de dispositifs électroniques, tels que notamment des mémoires NAND effaçables utilisées dans les clés USB, les cartes MS et les cartes SD pour le stockage et le transfert général des données.

Un deuxième objet de l'invention concerne un procédé de formation d'une couche de nickel ou de cobalt sur un substrat de silicium comprenant les étapes consistant à :
- exposer la surface du substrat comprenant du silicium avec une solution aqueuse contenant des ions or, des ions fluor et un agent tensio-actif choisi parmi les polymères et les composés comprenant un groupement polaire anionique ou non ionique et une chaîne alkyle comprenant de 10 à 14 atomes de carbone, de manière à former des particules d'or métallique, et
- déposer par voie electroless sur le substrat recouvert de particules d'or une couche constituée essentiellement de nickel ou de cobalt et d'épaisseur comprise entre 10 et 150 nm, de préférence de 10 à 40 nm, et de préférence encore de 10 à 25 nm.

Les caractéristiques qui ont été décrites en rapport avec le premier objet de l'invention peuvent s'appliquer au deuxième objet de l'invention.

Un troisième objet de la présente invention est un procédé de fabrication d'une mémoire NAND comprenant un procédé de formation de siliciure de nickel ou de siliciure de cobalt tel que décrit précédemment.

Un quatrième autre objet de l'invention porte sur un procédé de fabrication de cellules photovoltaïques comprenant un procédé de formation de siliciure de nickel ou de siliciure de cobalt tel que décrit précédemment.

L'invention sera mieux comprise à la lecture de la description des exemples non limitatifs suivants faite en référence aux figures annexées.
La Figure 1 représente deux images au microscope électronique à balayage montrant les nanoparticules d'or sur la surface de silicium polycristallin obtenues A) en l'absence d'agent tensio-actif et B) en présence d'agent tensio-actif.
La Figure 2 représente une image obtenue au microscope électronique à balayage montrant le dépôt d'une couche très fine de l'alliage de nickel (<20 nm) après activation avec la solution de l'invention.
La Figure 3 est une image obtenue au microscope électronique à balayage montrant la couche de siliciure de nickel NiSi (<40 nm) obtenue après recuit thermique (350°C/1 min) et nettoyage du nickel non réagi ou non migré.

Les exemples qui suivent ont été réalisés à l'échelle du laboratoire.

Sauf indication contraire, ces exemples ont été réalisés dans des conditions normales de température et de pression (environ 25°C sous environ 1 atm) à l'air ambiant, et les réactifs utilisés ont été directement obtenus dans le commerce sans purification supplémentaire.

### Exemple 1 de référence : Activation d'un substrat recouvert d'une couche de silicium polycristallin à partir d'une solution contenant un sel de métal noble et d'acide fluorhydrique.

### a) Nettoyage des surfaces :

En fonction de l'origine du substrat et de ses besoins, l'homme de l'art saura adapter un protocole de nettoyage de la surface. Dans notre cas aucun nettoyage n'a été nécessaire puisque la solution d'activation est aussi une solution de gravure lente. Dans cet exemple, le substrat utilisé est un coupon de silicium de 1 cm x 2 cm de côté et 750 µm d'épaisseur recouvert d'une couche de dioxyde de silicium (SiO₂) ayant une épaisseur d'environ 90 nm, elle-même recouverte d'une couche de silicium polycristallin avec une épaisseur d'environ 190 nm.

### b) Activation de la surface du substrat :

### b1) Préparation de la solution d'activation :

Dans un bécher en PTFE propre, 50 ml d'un mélange d'acide fluorhydrique à 2.5% massique (1.5 M) et 15 mg du sel de métal noble choisi est préparé à température ambiante. Le tableau 1 renseigne le type et la quantité de sel de métal noble utilisés.

### b2) Traitement d'activation de la surface du substrat :

Le substrat décrit dans l'étape a) est immergé pour un temps donné (voir tableau 1) dans le mélange préparé dans l'étape b1). Le substrat ainsi traité est abondamment rincé à l'eau déionisée et séché sous un flux d'azote.

### c) Dépôt d'une couche de métal NiB par procédé électroless :

### c1) Préparation préliminaire de la solution d'électroless :

Dans un récipient de 1 litre et un minimum d'eau déionisée sont introduits dans l'ordre, 31.11 g de sulfate de nickel hexahydraté (0.118 moles), 44.67 g d'acide citrique (0.232 moles), 52,26 g de N-méthyl-éthanolamine (0.700 moles) et 2.5 ppm de polyéthyleneimine (PEI) de Mn = 600 g/mole. Le pH final a été ajusté à 9 avec la base et le volume total a été ajusté à 1 litre avec de l'eau déionisée.

A neuf volumes de la solution précédente, juste avant l'étape suivante, un volume d'une solution réductrice est ajouté. Cette dernière comprend 28 g/l de diméthyl-amino borane (DMAB; 0.475 moles) et 60.00 g de N-méthyl-éthanolamine (0.798 moles).

### c2) Formation de la couche d'alliage NiB sur la couche de silicium polycristallin:

Une couche d'alliage de nickel NiB a été déposée sur la surface du substrat traité dans l'étape b) en l'immergeant dans la solution d'électroless préparée auparavant et portée à 65°C, pour une période de 30 secondes à 5 minutes, selon l'épaisseur finale désirée.

### d) Formation du siliciure de nickel :

L'échantillon obtenu dans l'étape c), avec l'alliage de nickel dessus, est soumis à un recuit thermique rapide (en anglais : Rapid Thermal Annealing ; RTA) à 350°C pendant une minute. L'opération peut être effectuée avec un four tubulaire ou une plaque chauffante.

### Résultats:

**Tableau 1**

| Entrée | Sel de métal noble | Concentration de sel de métal noble (ppm) | Concentration en HF (M) | Temps d'activation (en sec.) | Déposition de Nickel par Electroless | Diffusion du nickel dans le silicium | Epaisseur minimale de la couche de nickel (nm) |
|---|---|---|---|---|---|---|---|
| 1 | (NH₄)₂PdCl₄ | 240 | 1,5 | 30 | oui | Diffusion non uniforme | 200 |
| 2 | CuSO₄ | 240 | 1,5 | 30 | oui | non | 50 |
| 3 | AgAc | 240 | 1,5 | 30 | oui | non | 60 |
| 4 | HAuCl₄ | 240 | 1,5 | 30 | oui | oui | 50 |

### Commentaires :

Cette première série de tests permet de mettre en exergue l'importance de la nature du métal noble utilisé pour la migration du nickel dans le silicium. Les solutions de palladium (II) sont capables d'activer la surface mais donnent des épaisseurs de nickel conformes bien supérieures à celles visées. On observe par ailleurs que les sels d'argent et de cuivre ne permettent pas d'induire la migration du nickel dans le silicium à une température de traitement thermique de 350°C. Enfin, le sel d'or (III) permet d'obtenir une couche fine d'alliage de nickel-bore, mais aussi la migration uniforme de ce dernier dans le silicium.

### Exemule 2: Activation d'un substrat recouvert d'une couche de silicium polycristallin à partir d'une solution selon l'invention contenant un sel d'or (III), de l'acide fluorhydrique et un agent tensio-actif.

### a) Nettoyage des surfaces :

Cette étape est identique à l'étape a) de l'exemple 1.

### b) Activation de la surface du substrat :

### b1) Préparation de la solution d'activation selon l'invention :

Dans un bécher en PTFE propre, 50 ml d'un mélange d'acide fluorhydrique à 2.5% massique, 240 ppm d'hydrochlorure d'or (III) et un agent tensio-actif (voir tableau 2) a été préparé à température ambiante.

### b2) Traitement d'activation de la surface du substrat :

Le substrat décrit dans l'étape a) est immergé pour un temps donné (voir table 2), dans ce cas 30 secondes, dans le mélange préparé dans l'étape b1). Le substrat ainsi traité est abondamment rincé à l'eau déionisée et séché sous un flux d'azote.

### c) Dépôt d'un couche de metal NiB par electroless :

### c1) Préparation préliminaire de la solution d'électroless :

La solution d'électroless utilisée et les conditions d'utilisation sont identiques à celles de l'étape c1), exemple 1.

### c2) Formation de la couche d'alliage de nickel NiB sur la couche de silicium polycristallin :

Une couche d'alliage de métal NiB a été préparée sur la surface du substrat traité dans l'étape b) en l'immergeant dans la solution d'électroless préparée auparavant et portée à 65°C, pour une période de 30 secondes à 5 minutes, selon l'épaisseur finale désirée. La durée d'immersion dans la solution d'électroless est déterminée de façon à obtenir une épaisseur de nickel minimum avec une bonne uniformité et conductivité.

On mesure l'épaisseur de la couche par microscopie électronique à balayage en faisant une coupe transversale de l'échantillon.

La méthode permettant de mesurer la conductivité et l'uniformité est la mesure de mesure à quatre pointes connue de l'homme du métier.

Les résultats sont présentés dans la Table 2 où l'épaisseur minimum est obtenue avec différents stabilisateurs.

**Tableau 2 :**

| N° d'essai | Concentration en HAuCl₄ (mM) | Concentration en HF (M) | Nature du tensio-actif | Concentration en tensio-actif (g/l) | Epaisseur de la couche de nickel (nm) |
|---|---|---|---|---|---|
| 1 comparatif | 0.7 mM | 1,5 | aucun | / | 50 |
| 2 comparatif | 0.7 mM | 1,5 | Polyvinyl-pyrrolidinone (PVP) 3500 g/mole | 3 | 45 |
| 3 | 0.7 mM | 1,5 | Brij 35* 1225 g/mole | 3 | 40 |
| 4 | 0.7 mM | 1,5 | Sodium dodecyl sulphate (SDS) 288 g/mol | 3 | 20 |

| | | | | | |
|---|---|---|---|---|---|
| *Brij 35 : polyoxyéthylèneglycol dodécyl éther | | | | | |

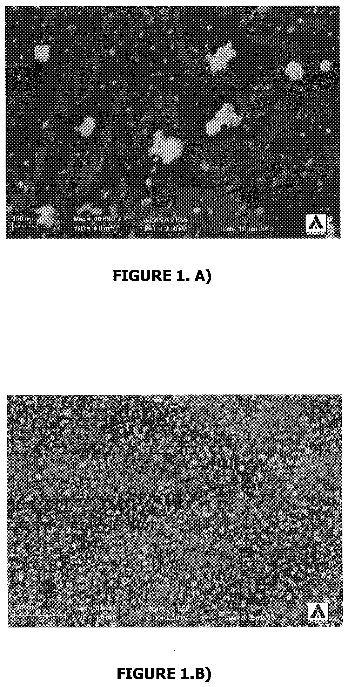

Cette seconde série montre l'impact positif d'un tensio-actif de faible poids moléculaire pour stabiliser les nanoparticules d'or formées après réaction d'oxydo-réduction avec le silicium polycristallin. En additionnant un agent de stabilisation dans le bain d'activation, la taille des particules d'or métallique peut être diminuée tout en augmentant leur densité. Cette répartition des particules d'or permet de déposer une couche de nickel plus fine. Le meilleur résultat est obtenu avec un surfactant anionique (SDS) qui permet une stabilisation électro-stérique des nanoparticules sur la surface du silicium polycristallin alors que les tenioactifs non ioniques inducteurs de stabilisation stérique uniquement (Brij 35) ne le permettent pas. La molécule SDS stabilise les nanoparticules d'or et augmente leur concentration sur la surface du silicium polycristallin (voir Figure 1B).

### d) Formation du siliciure de nickel:

Comme dans l'étape d), exemple 1, l'échantillon obtenu dans l'étape c), recouvert d"alliage de nickel, est soumis à un recuit thermique rapide à 350°C pendant une minute. L'échantillon est ensuite traité par une solution chimique afin d'éliminer le nickel n'ayant pas réagi.

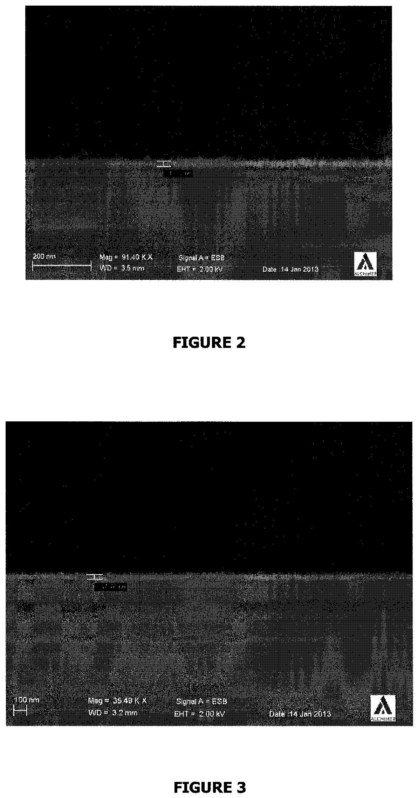

Une coupe de l'échantillon de l'essai 4 est observée au microscope électronique à balayage avant et après recuit thermique et gravure chimique. L'épaisseur de 20 nm de la couche de l'alliage de nickel obtenue après activation et dépôt d'électroless est montrée en Figure 2. La couche fine et très homogène de siliciure de nickel formée après recuit thermique est présentée dans la Figure 3.

La couche de siliciure de nickel (NiSi) est très homogène avec une épaisseur deux fois supérieure à celle de la couche de l'alliage de nickel initiale. Une parfaite diffusion avec une réaction stoechiométrique entre le nickel et le silicium (Ni:Si = 1:1) est obtenue avec une bonne uniformité de la couche résultante.

## Revendications

1. Procédé de formation de siliciure de nickel ou de siliciure de cobalt comprenant les étapes consistant à :
- mettre en contact la surface d'un substrat comprenant du silicium avec une solution aqueuse contenant des ions or et des ions fluor pour former des particules d'or métallique,
- déposer par voie electroless, sur le substrat recouvert de particules d'or métallique, une couche constituée essentiellement de nickel ou de cobalt,
- appliquer un traitement thermique rapide à une température comprise entre 300°C et 750°C, de manière à former le siliciure de nickel ou le siliciure de cobalt,
**caractérisé en ce que** la solution aqueuse contient un agent tensio-actif choisi parmi les composés comprenant au moins un groupement polaire anionique ou non ionique et une chaîne alkyle comprenant de 10 à 16 atomes de carbone.

2. Procédé selon la revendication 1, **caractérisé en ce que** la surface du substrat comprenant du silicium est mise en contact avec la solution aqueuse pendant une durée comprise entre 5 secondes et 5 minutes.

3. Procédé selon l'une des revendications précédentes, **caractérisé en ce que** les ions fluor sont apportés par l'acide fluorhydrique (HF), le NH₄F, ou un de leurs mélanges.

4. Procédé selon l'une des revendications précédentes, **caractérisé en ce que** les ions or sont apportés par l'acide chloraurique (HAuCl₄).

5. Procédé selon l'une des revendications précédentes, **caractérisé en ce que** la solution aqueuse contient
- de 0.1 mM à 10 mM, de préférence de 0.5 mM à 1.0 mM, d'ions or, et
- de 0.6 M à 3.0 M, de préférence de 1.0 M à 2.0 M, d'ions fluor.

6. Procédé selon l'une des revendications précédentes, **caractérisée en ce que** la chaîne alkyle comprend de 10 à 14 atomes de carbone.

7. Procédé selon l'une des revendications précédentes, **caractérisée en ce que** la couche constituée essentiellement de nickel ou de cobalt a une épaisseur uniforme ou conforme comprise entre 10 et 150 nm, de préférence entre 10 et 60 nm.

8. Procédé selon l'une des revendications précédentes, **caractérisée en ce que** la couche constituée essentiellement de nickel ou de cobalt est une couche de nickel-bore déposée en exposant la surface du substrat activé à une solution aqueuse contenant un sel de nickel, un agent réducteur à base de bore, un agent stabilisant du nickel et une polyamine, le pH de la solution étant compris entre 9 et 12, et la température de la solution aqueuse étant comprise entre 50°C et 90°C.

9. Procédé selon l'une des revendications précédentes, **caractérisée en ce que** le substrat de silicium à revêtir comprend des structures verticales creuses présentant des dimensions telles que leur diamètre à l'ouverture est compris entre 20 et 100 nm, et leur profondeur est compris entre 500 nm et 3 microns.

10. Procédé selon l'une des revendications précédentes, **caractérisée en ce que** le substrat comprenant du silicium comprend une alternance verticale à sa surface de zones de silicium et de zones d'un diélectrique choisi parmi SiO₂, Si₃N₄, SiC, et SiOC.

11. Procédé selon l'une des revendications précédentes, **caractérisée en ce que** le nickel ou le cobalt qui n'a pas migré dans le silicium à l'issue de l'étape de traitement thermique peut être éliminé par nettoyage chimique.

12. Procédé selon l'une des revendications précédentes, **caractérisée en ce que** la température de traitement thermique va de 350°C à 450°C.

13. Procédé selon l'une des revendications précédentes, **caractérisée en ce que** l'agent tensio-actif a une masse moléculaire comprise entre 100 g/mol et 1500 g/mol.

14. Procédé selon la revendication précédente, **caractérisée en ce que** l'agent tensio-actif comprend un groupe polaire anionique.

15. Procédé selon la revendication 13 ou 14, **caractérisée en ce que** l'agent tensio-actif est le dodécylsulfate de sodium.

16. Procédé de formation d'une couche de nickel ou de cobalt sur un substrat de silicium comprenant les étapes consistant à :
- exposer la surface du substrat comprenant du silicium avec une solution aqueuse contenant des ions or et des ions fluor, et
- déposer par voie electroless sur le substrat activé une couche constituée essentiellement de nickel ou de cobalt et d'épaisseur comprise entre 10 et 150 nm,
**caractérisé en ce que** la solution aqueuse contient un agent tensio-actif choisi parmi les composés comprenant au moins un groupement polaire anionique ou non ionique et une chaîne alkyle comprenant de 10 à 16 atomes de carbone.

17. Procédé de fabrication d'une mémoire NAND comprenant un procédé de formation de siliciure de nickel ou de siliciure de cobalt tel que défini à l'une des revendications 1 à 15.

18. Procédé de fabrication de cellules photovoltaïques comprenant un procédé de formation de siliciure de nickel ou de siliciure de cobalt tel que défini à l'une des revendications 1 à 15.

## Patentansprüche

1. Verfahren zur Bildung von Nickelsilicid oder von Kobaltsilicid, umfassend die Schritte, die darin bestehen:
- die Oberfläche eines Silizium umfassenden Substrats mit einer wässrigen Lösung, die Goldionen und Fluorionen enthält, in Kontakt zu bringen, um metallische Goldpartikel zu bilden,
- auf dem mit metallischen Goldpartikeln überzogenen Substrat eine Schicht, die im Wesentlichen aus Nickel oder aus Kobalt besteht, stromlos abzuscheiden,
- eine schnelle Wärmebehandlung bei einer Temperatur zwischen 300 °C und 750 °C anzuwenden, um das Nickelsilicid oder das Ko baltsilicid zu bilden,
**dadurch gekennzeichnet, dass** die wässrige Lösung ein Tensid enthält, das aus den Verbindungen, die wenigstens eine anionische oder nicht ionische polare Gruppe und eine Alkylkette mit 10 bis 16 Kohlenstoffatomen umfassen, ausgewählt ist.

2. Verfahren nach Anspruch 1, **dadurch gekennzeichnet, dass** die Oberfläche des Silizium umfassenden Substrats für eine Dauer zwischen 5 Sekunden und 5 Minuten mit der wässrigen Lösung in Kontakt gebracht wird.

3. Verfahren nach einem der vorhergehenden Ansprüche, **dadurch gekennzeichnet, dass** die Fluorionen durch Fluorwasserstoffsäure (HF), NH₄F oder eine ihrer Mischungen zugeführt werden.

4. Verfahren nach einem der vorhergehenden Ansprüche, **dadurch gekennzeichnet, dass** die Goldionen durch Chlorogoldsäure (HAuCl₄) zugeführt werden.

5. Verfahren nach einem der vorhergehenden Ansprüche, **dadurch gekennzeichnet, dass** die wässrige Lösung enthält
- 0.1 mM bis 10 mM, vorzugsweise 0.5 mM bis 1.0 mM Goldionen und
- 0.6 mM bis 3.0 mM, vorzugsweise 1.0 mM bis 2.0 mM Fluorionen.

6. Verfahren nach einem der vorhergehenden Ansprüche, **dadurch gekennzeichnet, dass** die Alkylkette 10 bis 14 Kohlenstoffatome umfasst.

7. Verfahren nach einem der vorhergehenden Ansprüche, **dadurch gekennzeichnet, dass** die im Wesentlichen aus Nickel oder aus Kobalt bestehende Schicht eine gleichmäßige oder angemessene Dicke zwischen 10 und 150 nm, vorzugsweise zwischen 10 und 60 nm aufweist.

8. Verfahren nach einem der vorhergehenden Ansprüche, **dadurch gekennzeichnet, dass** die im Wesentlichen aus Nickel oder aus Kobalt bestehende Schicht eine Nickel-Bor-Schicht ist, die dadurch abgeschieden wird, dass die Oberfläche des aktivierten Substrats einer wässrigen Lösung, welche ein Nickelsalz, ein Reduktionsmittel auf der Basis von Bor, einen Nickelstabilisator und ein Polyamin enthält, ausgesetzt wird, wobei der pH-Wert der Lösung zwischen 9 und 12 liegt und wobei die Temperatur der wässrigen Lösung zwischen 50 °C und 90 °C liegt.

9. Verfahren nach einem der vorhergehenden Ansprüche, **dadurch gekennzeichnet, dass** das zu beschichtende Siliziumsubstrat vertikale Hohlstrukturen umfasst, die derartige Abmessungen aufweisen, dass ihr Durchmesser an der Öffnung zwischen 20 und 100 nm und ihre Tiefe zwischen 500 nm und 3 Mikrometer beträgt.

10. Verfahren nach einem der vorhergehenden Ansprüche, **dadurch gekennzeichnet, dass** das Silizium umfassende Substrat eine zu seiner Oberfläche vertikale Wechselfolge von Silizium-Bereichen und von Bereichen aus einem Dielektrikum, ausgewählt aus SiO₂, Si₃N₄, SiC und SiOC, umfasst.

11. Verfahren nach einem der vorhergehenden Ansprüche, **dadurch gekennzeichnet, dass** das Nickel oder das Kobalt, das am Ende des Wärmebehandlungsschrittes nicht in das Silizium gewandert ist, durch chemische Reinigung entfernt werden kann.

12. Verfahren nach einem der vorhergehenden Ansprüche, **dadurch gekennzeichnet, dass** die Temperatur der Wärmebehandlung von 350 °C bis 450 °C reicht.

13. Verfahren nach einem der vorhergehenden Ansprüche, **dadurch gekennzeichnet, dass** das Tensid eine molare Masse im Bereich zwischen 100 g/mol und 1500 g/mol aufweist.

14. Verfahren nach dem vorhergehenden Anspruch, **dadurch gekennzeichnet, dass** das Tensid eine anionische, polare Gruppe umfasst.

15. Verfahren nach Anspruch 13 oder 14, **dadurch gekennzeichnet, dass** das Tensid Natriumdodecylsulfat ist.

16. Verfahren zur Bildung einer Nickel- oder Kobaltschicht auf einem Siliziumsubstrat, umfassend die Schritte, die darin bestehen:
- die Oberfläche des Silizium umfassenden Substrats einer wässrigen Lösung, die Goldionen und Fluorionen enthält, auszusetzen,
- auf dem aktivierten Substrat eine Schicht, die im Wesentlichen aus Nickel oder aus Kobalt besteht und eine Dicke zwischen 10 und 150 nm aufweist, stromlos abzuscheiden,
**dadurch gekennzeichnet, dass** die wässrige Lösung ein Tensid enthält, das aus den Verbindungen, die wenigstens eine anionische oder nicht ionische polare Gruppe und eine Alkylkette mit 10 bis 16 Kohlenstoffatomen umfassen, ausgewählt ist.

17. Verfahren zur Herstellung eines NAND-Speichers, das ein Verfahren zur Bildung von Nickelsilicid oder von Kobaltsilicid, wie in einem der Ansprüche 1 bis 15 definiert, umfasst.

18. Verfahren zur Herstellung von Photovoltaikzellen, das ein Verfahren zur Bildung von Nickelsilicid oder von Kobaltsilicid, wie in einem der Ansprüche 1 bis 15 definiert, umfasst.

## Claims

1. A process for the formation of nickel silicide or of cobalt silicide comprising the stages consisting in:
- bringing the surface of a silicon-comprising substrate into contact with an aqueous solution comprising gold ions and fluorine ions in order to form particles of metallic gold,
- depositing by an electroless route, on the substrate covered with particles of metallic gold, a layer essentially composed of nickel or of cobalt,
- applying a rapid thermal annealing at a temperature of between 300°C and 750°C, so as to form the nickel silicide or the cobalt silicide,
**characterized in that** the aqueous solution comprises a surface-active agent chosen from the compounds comprising at least one anionic or nonionic polar group and an alkyl chain comprising from 10 to 16 carbon atoms.

2. The process as claimed in claim 1, **characterized in that** the surface of the silicon-comprising substrate is brought into contact with the aqueous solution for a duration of between 5 seconds and 5 minutes.

3. The process as claimed in either of the preceding claims, **characterized in that** the fluorine ions are contributed by hydrofluoric acid (HF), NH₄F or one of their mixtures.

4. The process as claimed in one of the preceding claims, **characterized in that** the gold ions are contributed by chloroauric acid (HAuCl₄).

5. The process as claimed in one of the preceding claims, **characterized in that** the aqueous solution comprises:
- from 0.1 mM to 10 mM, preferably from 0.5 mM to 1.0 mM, of gold ions, and
- from 0.6 M to 3.0 M, preferably from 1.0 M to 2.0 M, of fluorine ions.

6. The process as claimed in one of the preceding claims, **characterized in that** the alkyl chain comprises from 10 to 14 carbon atoms.

7. The process as claimed in one of the preceding claims, **characterized in that** the layer essentially composed of nickel or of cobalt has a uniform or conformal thickness of between 10 and 150 nm, preferably between 10 and 60 nm.

8. The process as claimed in one of the preceding claims, **characterized in that** the layer essentially composed of nickel or of cobalt is a nickel-boron layer deposited by exposing the surface of the activated substrate to an aqueous solution comprising a nickel salt, a boron-based reducing agent, a stabilizing agent for nickel and a polyamine, the pH of the solution being between 9 and 12 and the temperature of the aqueous solution being between 50°C and 90°C.

9. The process as claimed in one of the preceding claims, **characterized in that** the silicon substrate to be coated comprises hollow vertical structures exhibiting dimensions such that their diameter at the opening is between 20 and 100 nm and their depth is between 500 nm and 3 microns.

10. The process as claimed in one of the preceding claims, **characterized in that** the silicon-comprising substrate comprises a vertical alternation at its surface of regions of silicon and of regions of a dielectric chosen from SiO₂, Si₃N₄, SiC and SiOC.

11. The process as claimed in one of the preceding claims, **characterized in that** the nickel or the cobalt which has not migrated into the silicon on conclusion of the thermal annealing stage can be removed by chemical cleaning.

12. The process as claimed in one of the preceding claims, **characterized in that** the thermal annealing temperature ranges from 350°C to 450°C.

13. The process as claimed in one of the preceding claims, **characterized in that** the surface-active agent has a molecular weight of between 100 g/mol and 1500 g/mol.

14. The process as claimed in the preceding claim, **characterized in that** the surface-active agent comprises an anionic polar group.

15. The process as claimed in claim 13 or 14, **characterized in that** the surface-active agent is sodium dodecylsulfate.

16. A process for the formation of a nickel or cobalt layer on a silicon substrate, comprising the stages consisting in:
- exposing the surface of the silicon-comprising substrate with an aqueous solution comprising gold ions and fluorine ions, and
- depositing by an electroless route, on the activated substrate, a layer essentially composed of nickel or of cobalt and with a thickness of between 10 and 150 nm,
**characterized in that** the aqueous solution comprises a surface-active agent chosen from compounds comprising at least one anionic or nonionic polar group and an alkyl chain comprising from 10 to 16 carbon atoms.

17. A process for the manufacture of a NAND memory comprising a process for the formation of nickel silicide or of cobalt silicide as defined in one of claims 1 to 15.

18. A process for the manufacture of photovoltaic cells comprising a process for the formation of nickel silicide or of cobalt silicide as defined in one of claims 1 to 15.
